# EUROPÄISCHE PATENTANMELDUNG

(11) **EP 1 158 758 A2**
(43) Veröffentlichungstag der Anmeldung: **28.11.2001**
(21) Anmeldenummer: 01110122.7
(22) Anmeldetag: 03.05.2001
(51) Int. Cl.: H04N 1/00

(54) **Verbesserter Wartungszugang zu einem Scanner**

(30) Priorität: 17.05.2000 US 572101
(71) Anmelder: NexPress Solutions LLC, Rochester, NY 14653-7103 (US)
(72) Erfinder: Bailey, Steven, Rochester, NY 14616 (US); McMullen, Robert, Fairport, NY 14450 (US); Son, Woogie, Penfield, NY 14526 (US); Wetzel, Thomas Joseph, Rochester, NY 14612 (US)
(74) Vertreter: Franzen, Peter

(57) **Zusammenfassung**

Ein Scanner mit einer Schaltkartenanordnung, die gewartet werden kann und eine stufenweise Anordnung aufweist. Der Scanner hat eine Steckplatzvorrichtung zum Befestigen der Schaltkarten in der Rückseite des Scanners. Die Steckplatzvorrichtung hat eine Zugangsöffnung. Eine erste Schaltkarte und eine zweite Schaltkarte sind in der Steckplatzvorrichtung befestigt. Die erste Schaltkarte hat eine Aussparung. Die zweite Schaltkarte umfasst einen sichtbaren Abschnitt, der durch die Zugangsöffnung und die Aussparung sichtbar und zugänglich ist. Die Prüfstellen und Leuchtdioden sind innerhalb des sichtbaren Abschnitts der zweiten Schaltkarte angeordnet.

## Beschreibung

Die vorliegende Erfindung betrifft eine Dokumentscanvorrichtung, insbesondere Hochleistungsdokumentscanner mit Schaltkartenanordnungen.

Eine typische Hochleistungsdokumentscannervorrichtung umfasst einen Scanner und eine Scannerhost-Workstation mit einer Scanner-Anwender Schnittstelle. Der Scanner wird auf einem Tisch neben oder in der Nähe der Scannerhost-Workstation aufgebaut. Der Scanner wiegt um die 90 kg. Wenn der Scanner installiert ist, befindet sich die Rückseite des Scanners üblicherweise an der Wand, so dass kein Zugang zur Rückseite des Scanner möglich ist.

Die Steuerungsschaltung ist bei den meisten Scannern in der Rückseite des Scanners angeordnet. Die Steuerungsschaltung umfasst elektrische Prüfstellen und Leuchtdiodenstatusindikatoren (LED-Statusindikatoren). Wenn der Scanner an der Wand steht, ist es unmöglich, die Prüfstellen und LED-Indikatoren zu sehen und Zugang zu ihnen zu bekommen. Um eine Wartung vorzunehmen, muss der Scanner bewegt werden. Dies ist wegen des Gewichts schwierig, zumal der Scanner üblicherweise im Laufe einer Fehlerdiagnose mehrere Male gewendet werden muss, um Zugang zu den wichtigsten elektrischen Komponenten zu erhalten.

Die neueren Scanneraufbauten umfassen waagerechte Schaltkarten, was die Wartung noch komplizierter macht. Während die waagerechten Schaltkarten die Größe des Scanners reduzieren, behindern sie den Zugang zu den und die Sicht auf die LED-Indikatoren und die Prüfstellen noch mehr. Selbst wenn die Schaltkarten senkrecht angeordnet wären, macht die überlappende Struktur der Schaltkartenanordnungen es schwierig, die Prüfstellen und LED-Indikatoren auf den Schaltkarten zu sehen und Zugang zu ihnen zu haben, weil andere Schaltkarten im Wege sind.

Die vorliegende Erfindung schafft einen Scanner mit einer Schaltkartenanordnung, der leicht gewartet werden kann. Der Scanner ermöglicht ein Überprüfen von Prüfstellen und Leuchtdioden von derselben Stelle außerhalb des Scanners, ohne den Scanner zu bewegen. Die Überprüfung kann von vome oder den Seiten des Scanners erfolgen.

Der Scanner umfasst eine Steckplatzvorrichtung zur Aufnahme von Schaltkarten in der Rückseite des Scanners. Die Steckplatzvorrichtung weist eine Zugangsöffnung auf. Eine erste Schaltkarte und eine zweite Schaltkarte sind in der Steckplatzvorrichtung befestigt. Die erste Schaltkarte hat eine Aussparung. Die zweite Schaltkarte hat einen sichtbaren Abschnitt, der durch die Zugangsöffnung und die Aussparung sichtbar und zugänglich ist. Die Prüfstellen und Leuchtdioden sind innerhalb des sichtbaren Abschnitts der zweiten Schaltkarte angeordnet. Die Prüfstellen sind in so zugänglich, dass sie mit einer Messsonde verbunden werden können. Die Kombination der Aussparung auf der ersten Schaltkarte und des sichtbaren Abschnitts auf der zweiten Schaltkarte schaffen eine stufenweise Anordnung, die auf Anordnungen mit mehr als zwei Schaltkarten anwendbar ist.

Weitere Vorteile der vorliegenden Erfindung gehen aus den nachfolgenden Zeichnungen und der Beschreibung hervor.

Die vorliegende Erfindung wird nachfolgend mit Bezug auf die Zeichnungen anhand bevorzugter Ausführungsformen beschrieben.

In den Zeichnungen zeigen:
- Fig. 1: eine perspektivische Ansicht einer Hochleistungsdokumentscanvorrichtung mit einem Scanner gemäß einer bevorzugten Ausführungsform der vorliegenden Erfindung,
- Fig. 2: eine perspektivische Vorderansicht eines Scanners ohne den automatischen Dokumenteinzug gemäß einer bevorzugten Ausführungsform der vorliegenden Erfindung,
- Fig. 3: eine perspektivische Rückansicht eines Scanners gemäß einer bevorzugten Ausführungsform der vorliegenden Erfindung,
- Fig. 4: eine perspektivische Ansicht einer Steckplatzvorrichtung für einen Scanner gemäß einer bevorzugten Ausführungsform der vorliegenden Erfindung,
- Fig. 5: eine Draufsicht auf die Bewegungssteuerungskarte für die Steckplatzvorrichtung aus Fig. 4 und
- Fig. 6: eine Draufsicht auf die Hauptprozessoreinheit-Schaltkarte (CPU-Schaltkarte) für die Steckplatzvorrichtung aus Fig. 4.

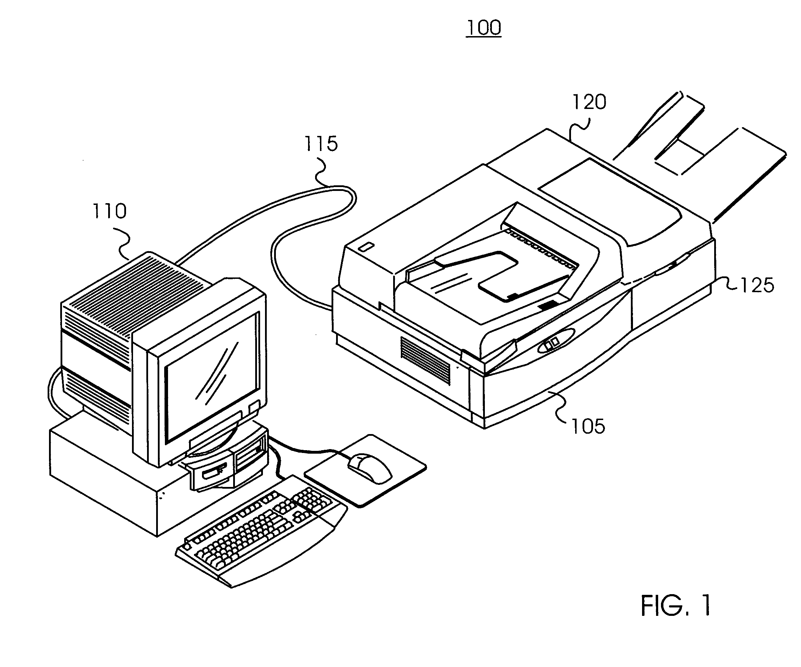

Fig. 1 zeigt eine erfindungsgemäßen Hochleistungsdokumentscanvorrichtung 100 mit einem Scanner 105. Ein kleines Rechnersystemschnittstellenkabel (SCSI-Kabel) 115 verbindet den Scanner 105 mit einer Scannerhost-Workstation 110, die eine Scanner-Benutzerschnittstelle hat. Die Scannerhost-Workstation 110 kann ein PC oder ein anderes auf einem Mikroprozessor basierendes System sein. Der Scanner 105 umfasst einen automatischen Dokumenteinzug 120, der mit dem Scannergehäuse 125 betriebsfähig verbunden und auf dem Gehäuse befestigt ist.

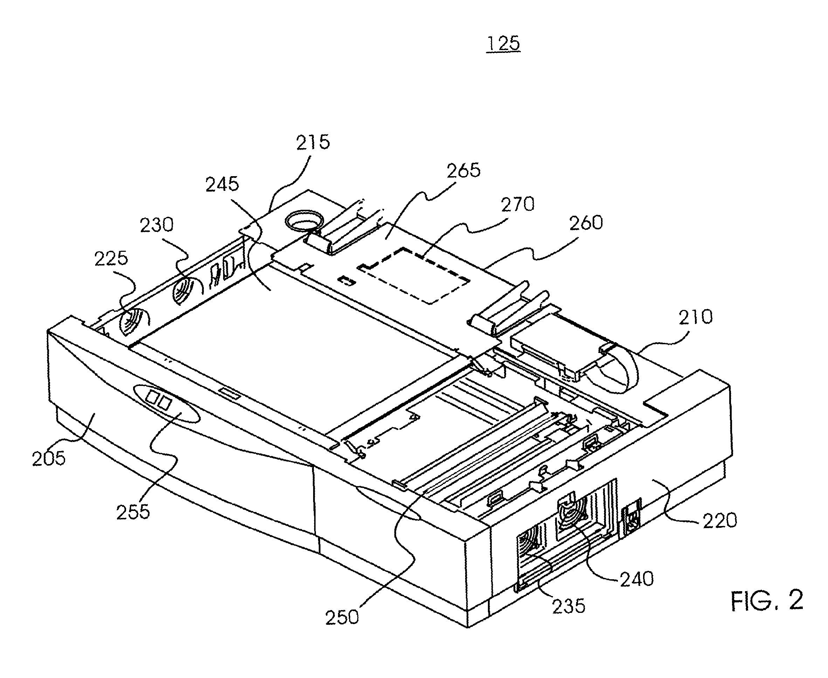

In Fig. 2 ist ein Scannergehäuse 125 ohne den automatischen Dokumenteinzug 120 dargestellt. Das Scannergehäuse 125 weist eine Vorderseite 205, eine Rückseite 210, eine linke Seite 215 und eine rechte Seite 220 auf. Entlang der linken Seite 215 sind der linke vordere Belüfter 225 und der linke hintere Belüfter 230 angeordnet. Entlang der rechten Seite 220 sind der rechte vordere Belüfter 235 und der rechte hintere Belüfter 240 angebracht. Die Belüfter 225, 230, 235, 240 sind in Betrieb, so oft der Scanner 105 in Betrieb ist, um das Scannergehäuse 125 mit einem kühlenden Luftstrom zu versorgen.

Eine Vorlagenglas 245 und eine Belichtungslampe 250 sind in dem Scannergehäuse 125 angebracht. Die Belichtungslampe 250 ist in der betriebsbereiten Position am Vorlagenglas 245 angrenzend angeordnet. Das Vorlagenglas 245 ist so angeordnet, dass die Dokumente zum Scannen auf dem Vorlagenglas 245 platziert werden können. Das Vorlagenglas 245 ist so angeordnet, dass es mit dem automatischen Dokumenteinzug 120 zusammenarbeitet.

Die Anzeige 255 ist an der Vorderseite 205 des Scannergehäuses 125 angeordnet. Die Anzeige 255 hat Start-, Stopschalter und Leuchtdioden, die den Scannerstatus angeben.

Eine Schaltkartenanordnung oder Steckplatzvorrichtung 260 ist in der Nähe der Mitte der Rückseite 210 und unterhalb einer oberen Rahmenabdeckung 265 des Scannergehäuses 125 angeordnet. Die obere Rahmenabdeckung 265 verschließt eine Zugangsöffnung 270. Die Steckplatzvorrichtung 260 umfasst eine elektronische Schaltanordnung, die die wichtigsten Steuerungsfunktionen für den Scanner 120 liefert. Diese elektronische Schaltanordnung umfasst Schaltkarten (nicht dargestellt), die mittels Kabelsträngen (nicht dargestellt) elektrisch mit den Belüftern 225, 230, 235, 240, der Belichtungslampe 250, der Anzeige 255 und anderen elektrischen Komponenten (nicht dargestellt) in dem Scanner verbunden sind. Die Zugangsöffnung 270 führt zu den Schaltkarten (nicht dargestellt) in der Steckplatzvorrichtung 260. Die obere Rahmenabdeckung 265 ist verschiebbar, um die Zugangsöffnung 270 freizugeben.

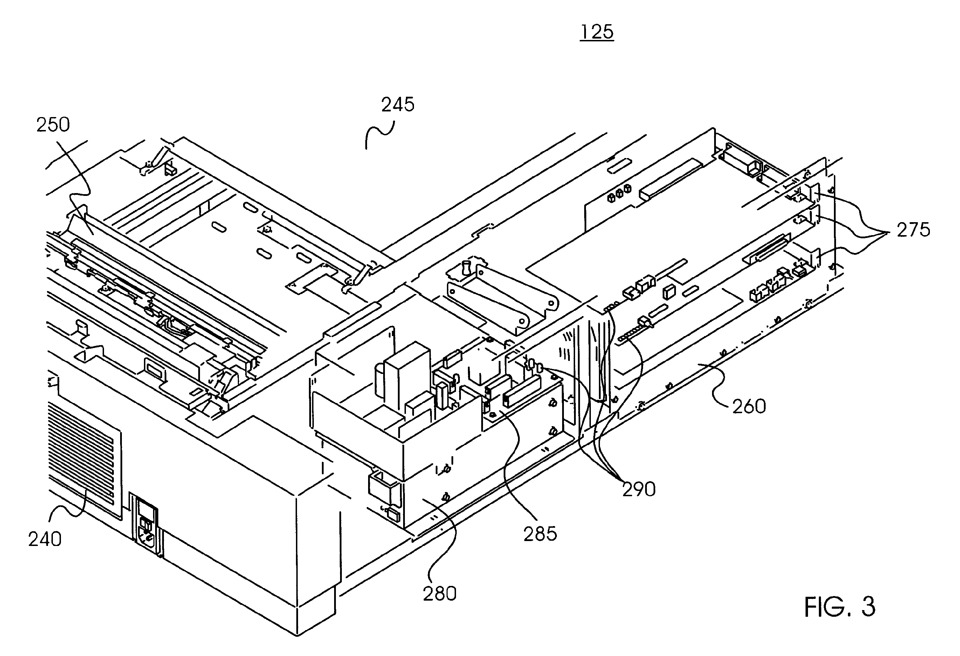

Fig. 3 zeigt eine vergrößerte Rückansicht des Scannergehäuses 125. Die obere Rahmenabdeckung 265 und andere Teile des Scannergehäuses 125 wurden entfernt, um die Steckplatzvorrichtung 260 zu zeigen. Mehrere Schaltkarten 275 sind in der Steckplatzvorrichtung 260 angeordnet. Ein Energiemodul 280 ist neben der Steckplatzvorrichtung 260 an der Hinterseite 210 des Scannergehäuses 125 angeordnet. Das Energiemodul 280 weist eine Gleichstromspannungsverteilerkarte 285 auf, welche die Schaltkarten 275 und andere elektrische Komponenten des Scanners 120 mit Gleichstromspannung versorgt. Die Schaltkarten 275 und die Spannungsverteilerkarte 285 weisen Leuchtdioden 290 auf, die über den Status Auskunft geben.

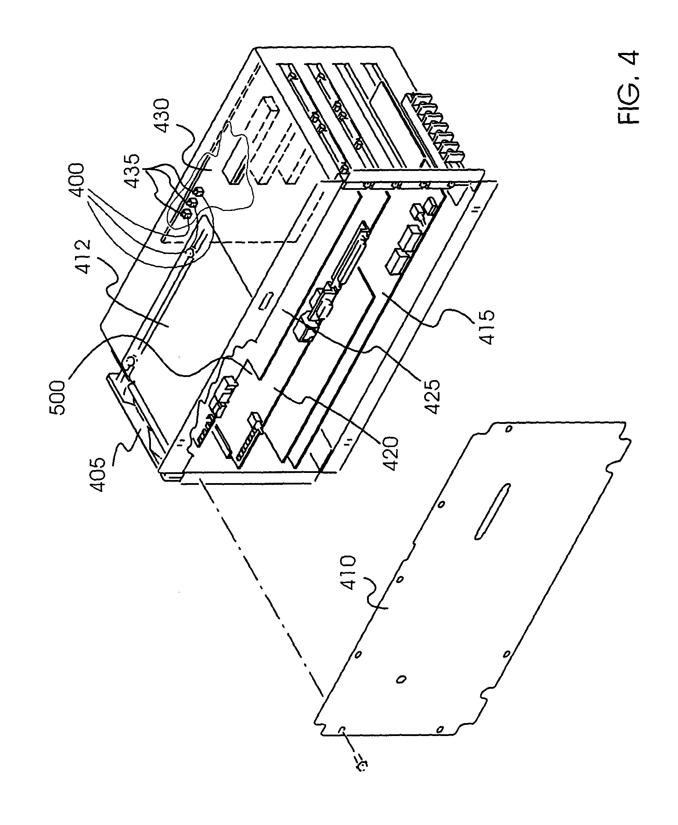

Fig. 4 zeigt eine vergrößerte Ansicht der Steckplatzvorrichtung 260, die einen Steckplatzvorrichtungsbelüfter 405, eine Steckplatzvorrichtungsrückseitenabdeckung 410 und eine Steckplatzvorrichtungszugangsabdeckung 412 aufweist. Die Steckplatzvorrichtung 260 besteht aus Blech und weist eine Befestigungsstruktur und EMS -Abschirmung für mehrere Schaltkarten auf. Eine Bildverarbeitungskarte 415 ist im Wesentlichen waagerecht in der Nähe des Bodens der Steckplatzvorrichtung 260 angeordnet. Eine CPU-Karte 420 befindet sich im Wesentlichen waagerecht über der Bildverarbeitungskarte 415. Ebenso ist eine Bewegungssteuerungskarte 425 im Wesentlichen waagerecht über der CPU-Karte 420 angeordnet.

Eine senkrecht befestigte Rückwandkarte 430 verbindet die Bildverarbeitungskarte 415, die CPU-Karte 420 und die Bewegungssteuerungskarte 425 miteinander. Die Rückwandkarte 430 weist Leuchtdioden 435 auf, die durch die Zugangslöcher 440 in der Steckplatzvorrichtung 260 sichtbar sind. Die Zugangslöcher können so ausgebildet sein, dass die Leuchtdioden in der Rückwand von der Vorderseite des Scanners 120 sichtbar sind. Die horizontalen Schaltkarten weisen Statusindikatoren oder Leuchtdioden 445 und Prüfstellen (nicht dargestellt) für die Wartung des Scanners 120 auf.

Die Prüfstellen ermöglichen eine Überwachung der Steuerungssignale für jede Scannerkomponente. Obwohl auch andere Formen verwendet werden können, weisen die Prüfstellen kleine Stifte auf, die in Reihen angeordnet von jeder der Schaltkarten hervorragen. Spannungsmessungen werden anhand einer Messprüfspitze (nicht dargestellt) gemessen, die in den Aufbau der Bewegungssteuerungskarte 425 integriert ist. Anhand der Messprüfspitze wird eine elektrische Verbindung mit den verschiedenen Prüfstellen hergestellt. Die Messungen werden vorgenommen, indem man ein Digitalmessinstrument an Standardteststecker (nicht dargestellt) anschließt. Diese Prüfpunkstecker liefern die elektrische Verbindungen zur Erde und zu der Messprüfspitze. In der Praxis werden die Messverbindungspunkte während eines Diagnosevorgangs nicht verändert. Die daraus hervorgehenden Spannungswerte werden vom Messinstrument angezeigt.

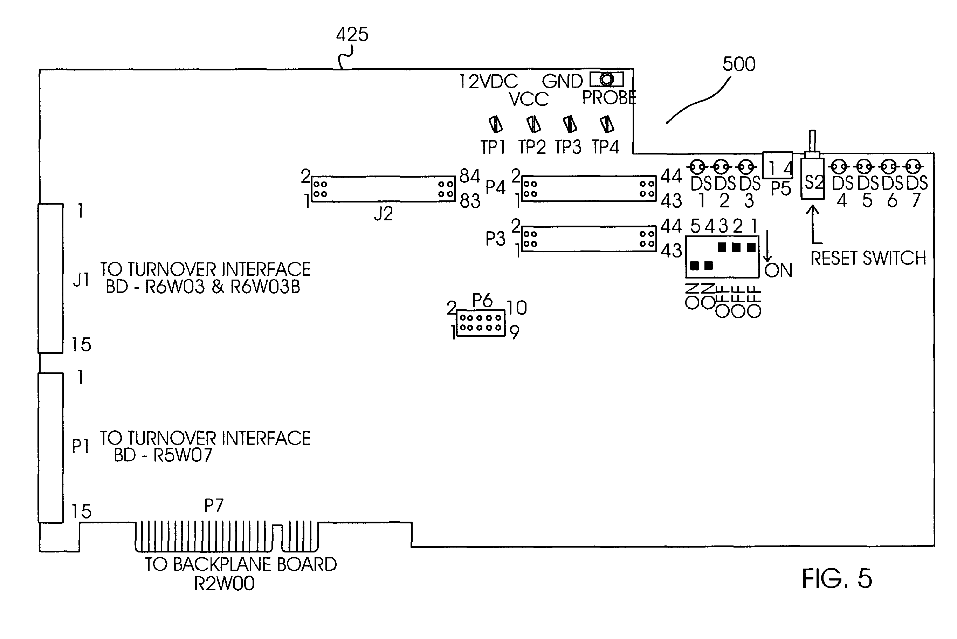

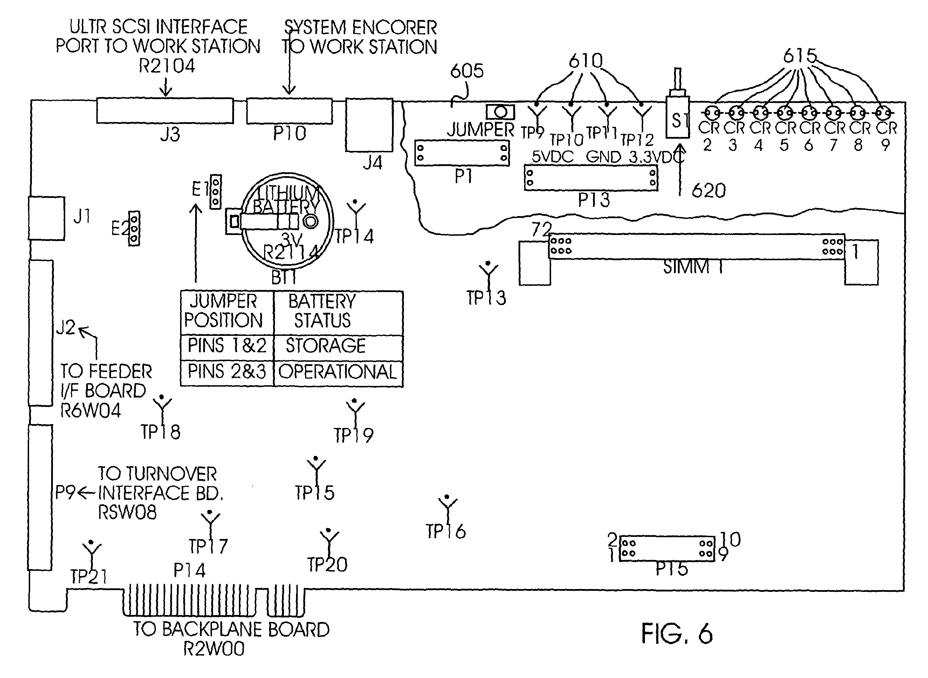

Die Bewegungssteuerungskarte 425 weist eine strategisch angeordnete Aussparung 500 zum Bilden einer Stufenkonfiguration mit der CPU-Karte 420 auf. Fig. 5 zeigt eine Draufsicht der Bewegungssteuerungskarte 425, die die Aussparung 500 aufweist. Wenn die Bewegungssteuerungskarte 425 und die CPU-Karte 420 in der Steckplatzvorrichtung 260 angeordnet sind, gibt die Aussparung 500 durch die Zugangsöffnung 270 den Blick auf einen Teil der CPU-Karte 420 frei. Fig. 6 zeigt eine Draufsicht der CPU-Karte 420, die den sichtbaren Abschnitt 605 aufweist. Der sichtbare Abschnitt 605 ist im Bereich der CPU-Karte 420 durch die Aussparung 500 auf der Bewegungssteuerungskarte 425 sichtbar. Der sichtbare Abschnitt 605 umfasst die Prüfstellen 610, die Leuchtdioden 615 der CPU und den Reset-Schalter 620. Eben diese Verbindung der Aussparung 500 und des sichtbaren Abschnitts 605 führt zu der Stufenkonfiguration.

Die stufenweise Anordnung ermöglicht den Zugang zu den Leuchtdioden und Prüfstellen in der Steckplatzvorrichtung 260. Indem das obere Rahmenabdeckung 265 entfernt wird, wird die Zugangsabdeckung 412 der Steckplatzvorrichtung 412 freigelegt, die sich dann öffnen lässt. Sobald die Abdeckung geöffnet ist, sind die Leuchtdioden und die Prüfstellen auf den verschiedenen Schaltkarten gleichzeitig sichtbar und durch die Zugangsöffnung 270 erreichbar, so dass die Wartung des Scanners 120 von der Vorderseite 205 her erfolgen kann.

Während bestimmte Formen und Proportionen für die Aussparung 500 und den sichtbaren Abschnitt 605 dargestellt sind, ist dennoch bekannt, dass die Aussparung 500 und der sichtbare Abschnitt 605 auch andere Formen und Proportionen haben können. Die Aussparung 500 und der sichtbare Abschnitt 605 können sich über die gesamte Länge oder Breite der jeweiligen Schaltkarten erstrecken.

Zusätzlich kann sich die stufenweise Anordnung über mehr als die zwei dargestellten Karten erstrecken. Die CPU-Karte 420 kann eine eigene Aussparung (nicht dargestellt) aufweisen, um einen sichtbaren Abschnitt der Bildverarbeitungskarte 415 freizulegen. Die CPU-Kartenaussparung und die Bewegungssteuerungsaussparung wären derart ausgerichtet, dass sie einen freien Blick auf den sichtbaren Abschnitt auf der Bildverarbeitungskarte zuließen. Es könnten weitere Karten verwendet werden. Der Bereich der Karten, der näher an der Zugangsöffnung liegt, würde sich vergrößern. Die stufenweise Anordnung ermöglicht den Zugang zu und einen Blick auf den sichtbaren Abschnitt auf jeder Karte und schafft damit die Möglichkeit, jede Karte von derselben Stelle außerhalb des Apparats zu prüfen. Wenngleich diese speziellen Schaltkarten in dieser speziellen Anordnung dargestellt sind, so sind dennoch andere Schaltkarten oder Anordnungen verwendbar. Die Aussparung kann auf senkrecht angeordneten Schaltkarten angeordnet sein und eine senkrecht angeordnete Zugangsabdeckung und -öffnung umfassen. Andere Anordnungen sind durch die Anwendung der Erfindung bekannt.

### Liste der Bezugszeichen

- 100: Dokumentscanvorrichtung
- 105: Scanner
- 110: Workstation
- 115: Rechnersystemschnittstellenkabel
- 120: Dokumenteinzug
- 125: Scannergehäuse
- 205: Vorderseite des Scannergehäuses
- 210: Rückseite des Scannergehäuses
- 215: linke Seite des Scannergehäuses
- 220: rechte Seite des Scannergehäuses
- 225: vorderer Belüfter
- 230: hinterer Belüfter
- 235: rechter vorderer Belüfter
- 240: rechter hinterer Belüfter
- 245: Vorlagenglas
- 250: Belichtungslampe
- 255: Auflageplatte
- 260: Steckplatzvorrichtung
- 265: obere Rahmenabdeckung
- 270: Zugangsöffnung
- 275: Schaltkarte
- 280: Leistungsmodul
- 285: Spannungsverteilerkarte
- 290: Leuchtdioden
- 405: Belüfter der Steckplatzanordnung
- 410: hintere Abdeckung der Steckplatzanordnung
- 412: Zugangsabdeckung der Steckplatzanordnung
- 415: Bildverarbeitungskarte
- 420: CPU-Karte
- 425: Bewegungssteuerungskarte
- 430: Rückwandkarte
- 435: Leuchtdioden in der Rückwandkarte
- 440: Zugangslöcher
- 445: Leuchtdioden bzw. Statusindikatoren
- 500: Aussparung
- 605: sichtbarer Abschnitt
- 610: Prüfstellen
- 615: Leuchtdioden der CPU
- 620: Reset-Schalter

## Patentansprüche

1. Scanner mit
einer ersten Schaltkarte mit einer Aussparung und
einer zweiten Schaltkarte, die mit der ersten Schaltkarte elektrisch verbunden ist, wobei die zweite Schaltkarte einen sichtbaren Abschnitt (605) aufweist,
**dadurch gekennzeichnet,**
**dass** der sichtbare Abschnitt für die Überprüfung durch die Aussparung sichtbar und zugänglich ist.

2. Scanner nach Anspruch 1,
**dadurch gekennzeichnet,**
**dass** er eine Schaltkartenanordnung umfasst, und
**dass** die erste und zweite Schaltkarte innerhalb der Schaltkartenanordnung angeordnet sind.

3. Scanner nach Anspruch 2,
**dadurch gekennzeichnet,**
**dass** die erste und die zweite Schaltkarte waagerecht angeordnet sind.

4. Scanner nach Anspruch 2 oder 3,
**dadurch gekennzeichnet,**
**dass** die Schaltkartenanordnung eine Zugangsöffnung bildet, wobei der sichtbare Abschnitt für die Überprüfung durch die Zugangsöffnung sichtbar und zugänglich ist.

5. Scanner nach einem der Ansprüche 1 bis 4,
**dadurch gekennzeichnet,**
**dass** die zweite Schaltkarte mindestens einen Statusindikator aufweist, der innerhalb des sichtbaren Abschnitts angeordnet ist.

6. Scanner nach Anspruch 5,
**dadurch gekennzeichnet,**
**dass** der mindestens eine Statusindikator eine Leuchtdiode ist.

7. Scanner nach einem der Ansprüche 1 bis 4,
**dadurch gekennzeichnet,**
**dass** die zweite Schaltkarte mindestens einer Prüfstelle aufweist, der innerhalb des sichtbaren Abschnitts liegt.

8. Scanner nach Anspruch 7,
**dadurch gekennzeichnet,**
**dass** die mindestens eine Prüfstelle für die Überprüfung durch die Aussparung sichtbar und zugänglich ist.

9. Scanner nach einem der Ansprüche 1 bis 8
**dadurch gekennzeichnet,**
**dass** die Schaltkarten in einer Steckplatzvorrichtung befestigt sind;
**dass** diese Steckplatzvorrichtung eine Zugangsöffnung hat;
**dass** eine erste Schaltkarte in der Steckplatzvorrichtung angeordnet ist, wobei die erste Schaltkarte eine erste Aussparung bildet;
**dass** eine zweite Schaltkarte in der Steckplatzvorrichtung an der ersten Schaltkarte angrenzend angeordnet ist, wobei die zweite Schaltkarte einen ersten sichtbaren Abschnitt umfasst und für Diagnosen durch die Zugangsöffnung und die Aussparung sichtbar und zugänglich ist.

10. Scanner nach Anspruch 9,
**dadurch gekennzeichnet,**
**dass** er eine dritte Schaltkarte, die in der Steckplatzvorrichtung an der zweiten Schaltkarte angrenzend angeordnet ist, wobei die dritte Schaltkarte eine zweiten sichtbaren Abschnitt umfasst, und
**dass** die zweite Schaltkarte eine zweite Aussparung hat,
wobei der zweite sichtbare Abschnitt für die Diagnose durch die Zugangsöffnung, die erste Aussparung und die zweite Aussparung sichtbar und zugänglich ist.

11. Scanner nach Anspruch 10,
**dadurch gekennzeichnet,**
**dass** die erste Schaltkarte, die zweite Schaltkarte und die dritte Schaltkarte waagerecht angeordnet sind.

12. Scanner nach Anspruch 10,
**dadurch gekennzeichnet,**
**dass** die zweite Schaltkarte eine erste Leuchtdiode innerhalb des ersten sichtbaren Abschnitts aufweist und die dritte Schaltkarte eine zweite Leuchtdiode innerhalb des zweiten sichtbaren Abschnitts aufweist.

13. Scanner nach Anspruch 10,
**dadurch gekennzeichnet,**
**dass** die zweite Schaltkarte umfasst eine erste Prüfstelle innerhalb des ersten sichtbaren Abschnitts und die dritte Schaltplatte umfasst eine zweite Prüfstelle innerhalb des zweiten sichtbaren Abschnitts.

14. Scanner nach Anspruch 13,
**dadurch gekennzeichnet,**
**dass** die erste Prüfstelle und die zweite Prüfstelle zur Überprüfung mit einem Messinstrument zugänglich sind.

15. Dokumentscanvorrichtung mit
einer Scanner-Host-Workstation, die eine Scanner-Anwender Schnittstelle aufweist; und
einem mit einer Scannerhost-Workstation verbundenen Scanner nach einem der Ansprüche 1 bis 14.
